# EUROPÄISCHE PATENTANMELDUNG

(11) **EP 1 187 521 A1**
(43) Veröffentlichungstag der Anmeldung: **13.03.2002**
(21) Anmeldenummer: 00119703.7
(22) Anmeldetag: 09.09.2000
(51) Int. Cl.: H05K 3/46, H01L 21/48

(54) **Verfahren zur Herstellung einer Trägerplatte für elektronische Bauteile**

(71) Anmelder: AB Mikroelektronik Gesellschaft m.b.H., 5020 Salzburg (AT)
(72) Erfinder: Wilczek, Klaus-Peter, 83404 Ainring (DE)
(74) Vertreter: Hofinger, Engelbert, Dr.Dr.

(57) **Zusammenfassung**

Verfahren zur Herstellung einer Trägerplatte für elektronische Bauteile, wobei die aus Kupfer bestehende Auflage einer isolierenden Grundplatte (1) zur Bildung von Basisleiterbahnen (3,3') teilweise entfernt wird und die Basisleiterbahnen (3,3') mit Pasten überdruckt werden, welche anschließend gesintert werden und leitende (4) und nichtleitende (5) Bereiche bilden.

## Beschreibung

Die Erfindung bezieht sich auf ein Verfahren zur Herstellung einer Trägerplatte für elektronische Bauteile, wobei die aus Kupfer bestehende Auflage einer isolierenden Grundplatte zur Bildung von Basisleiterbahnen teilweise entfernt wird.

In der Leistungselektronik werden vermehrt Substrate eingesetzt, bei denen ein nichtleitendes Trägermaterial mit einer Kupferauflage verbunden ist. Das Trägermaterial ist üblicherweise Al₂O₃ mit einer Dicke von 0,38 mm - 1,0 mm, die Dicke der Kupferauflage typischerweise 0,3 mm. Wegen der Art der Verbindung von Kupferauflage und Trägermaterial spricht man von DCB (Direct Copper Bonding). Ein wesentlicher Nachteil dieser Substrate besteht darin, daß die Topologie der Schaltung mittels einer subtraktiven Ätztechnik hergestellt wird. Als Ätzreserve wird Siebdrucklack verwendet. Dieser ist von seiner Linienauflösung als eher grob zu bezeichnen, der Hinterätzfaktor des 0,3 mm dicken Cu kommt negativ dazu. Es ergibt sich aus den beiden Gründen eine grobe Leiterbahnstruktur mit min 0,6 mm breiten Bahnen mit min 0,5 mm breiten Abständen. Andererseits ist DCB ein hervorragendes Material als Träger für Leistungshalbleiter und kann wegen seiner guten mechanischen Festigkeit als Systemkomponente beim Modulbau (z.B. als Rückwand eines Gehäuses) eingesetzt werden. Die Halbleiter (bevorzugt MOSFET und IGBT) werden in diskreter, gehauster Bauform oder vermehrt als Halbleiterkristalle in Löt- oder Klebetechnik mit dem Substrat verbunden. Wünschenswert wäre es jedoch, auch andere SMI-Komponenten in kleiner Bauform wie Chips 0402-0603, SOT-23, S0-Gehäuse, QFP und ähnliche Spezialbauformen mit sehr engem Anschlußraster auf einem Substrat zu integrieren. Dies ist, wie bereits geschildert, wegen der groben Strukturen nicht möglich.

Wenn eine hohe Packungsdichte der elektronischen Elemente erwünscht ist, bevorzugt man aus dem angeführten Grund die sogenannte Hybridtechnik zur Herstellung der Schaltungen. Dabei werden zumindest Leiterbahnen, vorzugsweise aber auch Widerstände, als Paste auf ein nichtleitendes Substrat aufgedruckt und anschließend gesintert. Diese Technik erlaubt es u.a. leitende und nichtleitende Schichten übereinander anzuordnen und dadurch Leitungskreuzungen zu bilden, wie sie für hochkomplexe Schaltungen notwendig sind. Begrenzt wird diese sogenannte Hybridtechnik heute vor allem durch die begrenzte Leistungsaufnahme der aufgedruckten Bestandteile.

Viele aktuelle Anwendungen in der Automobilindustrie lösen die Problematik mit zwei getrennten Substraten, welche nebeneinander angeordnet werden und durch geeignete Verbindungstechniken, z.B. Drahtbonden, miteinander elektrisch verbunden werden. Dies ist sehr aufwendig und kostenintensiv, die elektrische Funktionskontrolle kann erst sehr spät durchgeführt werden, was erhöhtes Ausschußrisiko bedingt.

Erfindungsgemäß ist demgegenüber vorgesehen, die Vorteile von DCB und Dickschichttechnik zu vereinen, indem ausgehend von einer DCB-Platte aus dieser in üblicher Weise Leiterbahnen gebildet und diese anschließend durch ein Dielektrikum überdeckt werden, woraufhin in üblicher Dickschichttechnik eine Trägerplatte fertiggestellt wird, welche mit diskreten elektronischen Bauteilen bestückt werden kann.

Die hohe Leistungsaufnahme der Basisleiterbahnen, welche aus dem DCB-Substrat gewonnen werden, wird für die Gesamtschaltung erst richtig wirksam, wenn auch die anschließend im Dickschichtverfahren hergestellten Leitungen hinreichend große Querschnitte aufweisen. Dabei entsteht das Problem, daß diese Leiterbahnen in der zweiten Ebene gut leitbar sein sollen und eine ausreichende Haftfähigkeit zum dielektrischen Untergrund aufweisen müssen. Dies wird vorzugsweise dadurch erreicht, daß (vgl. AT 402 871 B) mindestens zwei Schichten einer Kupferteilchen enthaltenden Paste unmittelbar übereinander aufgetragen werden, wobei nach dem Auftragen jeder einzelnen Schicht das in dieser enthaltene Lösungsmittel ausgedampft wird, und daß alle Schichten gemeinsam gesintert werden. Auf diese Weise lassen sich Kupferschichten erzeugen, deren Dicke 0,15 - 0,20 mm beträgt, sodaß die Dimensionen der Leiterbahnen in beiden Ebenen gut aufeinander abgestimmt werden.

Die mehrschichtige Herstellung der aus einer Paste gesinterten Leiterbahn erlaubt insbesondere eine gut haftende unmittelbare Verbindung mit den im Untergrund verlaufenden Basisleiterbahnen.

Weitere Einzelheiten der Erfindung werden anschließend anhand der Zeichnung erläutert. In dieser zeigen

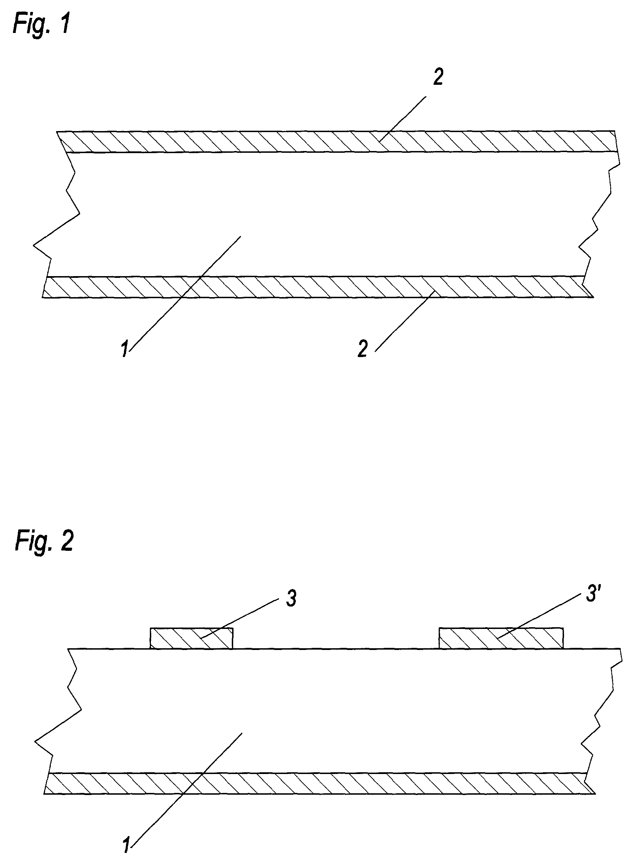

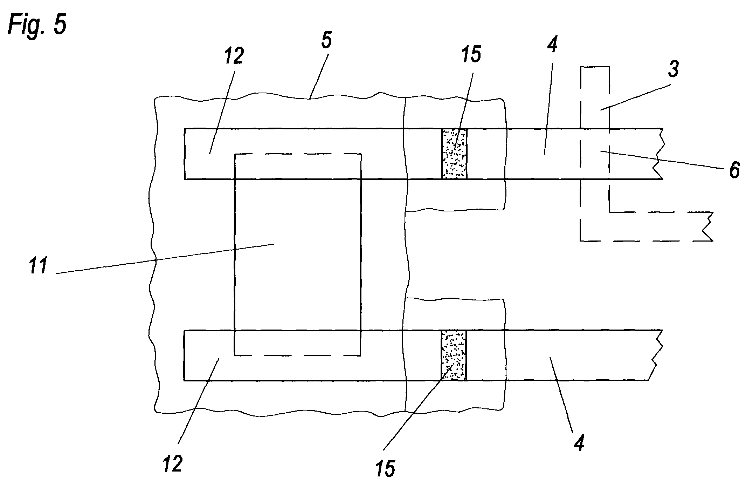

Fig. 1 - 4 schematisch verschiedene Stadien des Herstellungsverfahrens, Fig. 5 ist die Draufsicht auf eine nach dem erfindungsgemäßen Verfahren hergestellte Trägerplatte für eine Hybridschaltung.

Fig. 1 zeigt schematisch den Aufbau einer sogenannten DCB-Platte, also einer Platte aus einem Trägermaterial 1, auf welches vorzugsweise beidseitig Auflagen 2 aus massivem Kupfer mit einer Dicke von mehr als 0,1 mm aufgebracht sind. Solche Substrate sind unter verschiedenen Bezeichnungen im Handel erhältlich, und es ist üblich, die zunächst flächige obere Auflage 2 mittels Ätztechnik in einzelne Leiterbahnen 3,3' (vgl. Fig. 2) aufzulösen.

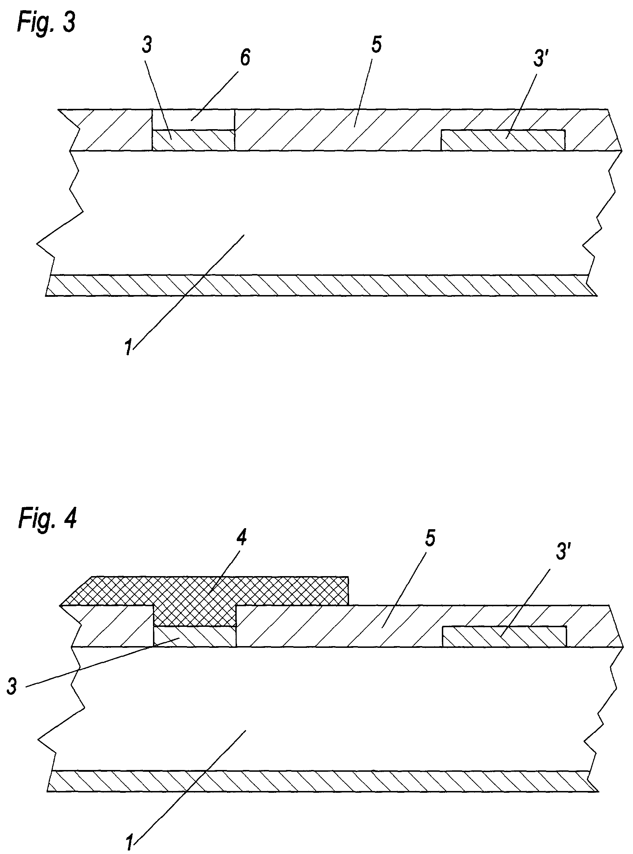

Das Neue an der Erfindung besteht darin, an diese Leiterbahnen 3,3' die vorgesehenen elektronischen Bauteile nicht oder nicht nur direkt anzuschließen, sondern oberhalb dieser Basisleiter weitere leitende und nichtleitende Schichten in Dickschichttechnik anzuordnen. Wie aus Fig. 3 hervorgeht, wird zunächst die Platte nach Fig. 2 mit einer nichtleitenden Schicht 5 in Form einer dielektrischen Paste bedruckt, welche unter Schutzgas eingebrannt wird. Vorzugsweise wird dabei zunächst nur der Zwischenraum zwischen den Basisleitern 3,3' gefüllt und erst in einem zweiten Auftragsvorgang das in Fig. 3 dargestellte Stadium erreicht, in welchem die nichtleitende Schicht 5 die Basisleiter 3,3' überall, abgesehen von einer Ausnehmung 6, überdeckt. Diese Ausnehmung 6 wird im nächsten Verfahrensschritt, der zum Ergebnis von Fig. 4 führt, mit leitender Kupferpaste ausgefüllt, was vorzugsweise durch Auftragen mehrerer Schichten erfolgt. Wegen der besonderen Bedeutung dieses Verfahrensschrittes wird anschließend hiefür ein Ausführungsbeispiel wiedergegeben:

Auf das Halbfabrikat nach Fig. 3 wurde mittels einer Metallschablone oder im Siebdruck eine Kupferpaste aufgetragen. Diese enthielt 75 Gew.-% Kupferpulver mit einer durchschnittlichen Teilchengröße von 3 und 8 Gew.-% eines pulverförmigen keramischen Flußmittels und eine organische Trägerflüssigkeit. Im vorliegenden Fall bestand das keramische Flußmittel aus einer Mischung von Zinkoxid, Kalziumoxid, Aluminiumoxid und Siliziumoxid. Die Verwendung von Bleioxid, Wismutoxid usw. wäre ebenso möglich.

Als organische Trägerflüssigkeit, welche der Paste die gewünschte Viskosität verleiht, wurde eine fünfprozentige Lösung von Ethylcellulose in Texanol verwendet.

Die Kupferpaste wurde in einer Lage von 60 µ Dicke partiell auf die Grundplatte aufgetragen und anschließend noch unter normaler Atmosphäre bei 120°C vom Lösungsmittel befreit. In gleicher Weise wurde eine zweite Schicht aufgetragen und das Lösungsmittel abgedampft und schließlich eine dritte Schicht aufgetragen und in gleicher Weise getrocknet. Anschließend wurde die beschichtete Platte in Stickstoffatmosphäre auf etwa 500°C erhitzt und die sich entwickelnden Gase, welche auf die Reste der organischen Trägerflüssigkeit zurückzuführen sind, entfernt. Bei weiterer Erhöhung der Temperatur bis auf schließlich 900°C kam es zum Schmelzen des Flußmittels und schließlich zur Sinterung der Kupferteilchen. Auf diese Weise wurde zunächst die Ausnehmung 6 in Fig. 3 ausgefüllt und anschließend im gleichen Verfahren der Rest der Leiterbahn 4 gebildet.

Die elektrischen Eigenschaften der fertigen Trägerplatte waren hervorragend, wobei sich vor allem eine Dicke der Gesamtschicht zwischen 150 bis 200 µ als günstig erwies. Beispielsweise konnte bei dem beschriebenen Ausführungsbeispiel mit einer Schichtdicke von 180 µ der Widerstand pro Flächeneinheit auf 0,25 mOhm gesenkt werden.

Fig. 5 zeigt einen Ausschnitt aus einem typischen elektrischen Schaltkreis in Hybridtechnik. Gemäß dieser Technik wird ein Substrat aus Keramik nicht nur mit Verbindungsbahnen für vorgefertigte Bauteile bedruckt, mit welchen die Trägerplatte bestückt wird. Vielmehr werden zusätzlich zumindest Widerstände ebenfalls direkt auf die Trägerplatte aufgebracht.

Im vorliegenden Fall wird ein Widerstand 11 gebildet, indem eine Paste aufgetragen wird, welche bei 800 - 950°C unter Luft eingebrannt wird. Ein derartiger Widerstand aus den Grundstrukturen Pd/Ag, RuO₂ oder Pyrochlor weist nach dem Sintem hervorragende elektrische Werte, wie niedriger Temperaturkoeffizient <50 ppm/K, hohe elektrische Belastbarkeit bis 100 W/mm², extreme Langzeitstabilität der Ohmwerte +/- 1% nach 130 000 Stunden Normalbetrieb, sehr guter Abgleichbarkeit der Widerstandswerte mit YAG-Laser bis zu +/- 0,1% Toleranz usw. auf.

Zur Kontaktierung des Widerstandes 11 dienen Kontakte 2 aus Edelmetall. Pasten zur Bildung von Leiterbahnen aus Ag, PdAg, AgPt, AgPdPt, Au, PdAu und ähnlichen Kombinationen für das Einbrennen an Luft bei 800 bis 950°C Brenntemperatur werden angeboten. Die Adhäsion der Pasten wird beim Sintervorgang durch Additive von Glas oder Oxidbildnem hergestellt. Es werden hiebei typische Haftfestigkeiten von 5 - 10 N/mm² erreicht. Alle genannten Pastensysteme sind empfindlich gegen thermische Alterung und zeigen tendenziell eine Verminderung der Haftfestigkeit nach Lagerung z.B. 1000 Stunden bei 150°C von 20 - 50 %. Gold- und silberhaltige Pasten haben zudem den Nachteil, mit den üblichen Weichlotlegierungen z.B. PbSn/PbSnAg eine eutektische Reaktion einzugehen, Silber/Gold löst sich bei Löttemperaturen von 220 - 250°C spontan in Zinn. Im Extremfall kommt es hiebei zum völligen Entnetzen der Paste und somit Ausfall der Schaltung durch Unterbrechungen oder Hochohmigkeit.

Die Verwendung derartiger Pasten zur Kontaktierung der Widerstände und Dielektrika ist trotz der an sich besseren Eignung von Kupfer als Leiterbahn notwendig. Nicht alle und vor allem nicht die besten Widerstände und Dielektrika sind nämlich mit Kupfer verträglich.

Zur Bildung der Hybridschaltung werden daher zunächst übereinander die Pasten aufgetragen, welche zur Bildung des Widerstandes 11 und der Kontakte 12 dienen. Nach dem Einbrennen aller Drucke gemeinsam bei z.B. 850°C an Luft wird im Siebdruck die Leiterbahn 4 aus Kupfer aufgebracht und getrocknet, anschließend eine z.B. nickelhältige Verbindungspaste zur Bildung einer Trennschicht 15, welche den Spalt zwischen Kontakt 12 und Leiterbahn 4 ausfüllt. Über die Widerstände und Verbindungszonen kann später eine zusätzliche Schutzschicht aus Glas oder Polymer aufgebracht werden.

Der Spalt zwischen Kontakt 12 und Leiterbahn 4 kann bei geeigneter Topologie unter Verwendung von Lot oder leitendem Kleber geschlossen werden.

Die in der dargestellten Weise geschaffene Leiterplatte kann nunmehr mit Bauelementen bestückt werden, welche eine hohe Leistungsaufnahme aufweisen, wobei insbesondere die Stromzufuhr über die Basisleiter 3,3' genützt wird. Gleichzeitig erlauben die durch die Dickschichttechnik erzielbaren feinen Strukturen die Integration aller gängigen Miniaturbauteile, insbesondere auch von Mikroprozessoren.

## Patentansprüche

1. Verfahren zur Herstellung einer Trägerplatte für elektronische Bauteile, wobei die aus Kupfer bestehende Auflage (2) einer isolierenden Grundplatte (1) zur Bildung von Basisleiterbahnen (3,3') teilweise entfernt wird, **dadurch gekennzeichnet, daß** die Basisleiterbahnen (3,3') mit Pasten überdruckt werden, welche anschließend gesintert werden und leitende (4) und nichtleitende (5) Bereiche bilden.

2. Verfahren nach Anspruch 1, **dadurch gekennzeichnet, daß** mindestens zwei Schichten einer Cu enthaltenden Paste unmittelbar übereinander aufgetragen werden, wobei nach dem Auftragen jeder einzelnen Schicht das in dieser enthaltene Lösungsmittel ausgedampft wird, und daß alle Schichten gemeinsam gesintert werden.
